# EUROPEAN PATENT APPLICATION

(11) **EP 4 300 494 A1**
(43) Date of publication of application: **03.01.2024**
(21) Application number: 23169740.0
(22) Date of filing: 25.04.2023
(51) Int. Cl.: G10L 21/0208, G10L 25/30

(54) **DEVICES FOR REAL-TIME SPEECH OUTPUT WITH IMPROVED INTELLIGIBILITY**

(30) Priority: 30.06.2022 US 202217810172
(71) Applicant: Baraff, David, Berwyn, PA 19312 (US)
(72) Inventor: Kang, Gene, New York, 10028 (US); Baraff, David, Berwyn, 19312 (US)
(74) Representative: Derry, Paul Stefan

(57) **Abstract**

Real-time speech output with improved intelligibility are described. One example embodiment includes a device. The device includes a microphone configured to capture one or more frames of unintelligible speech from a user. The device also includes an analog-to-digital converter (ADC) configured to convert the one or more captured frames of unintelligible speech into a digital representation. Additionally, the device includes a computing device. The computing device is configured to receive the digital representation from the ADC. The computing device is also configured to apply a machine-learned model to the digital representation to generate one or more frames with improved intelligibility. Further, the computing device is configured to output the one or more frames with improved intelligibility. In addition, the device includes a digital-to-analog converter (DAC) configured to convert the one or more frames with improved intelligibility into an analog form. Yet further, the device includes a speaker.

## Description

The present application hereby incorporates the following documents by reference in their entireties: U.S. Patent Application No. 09/641,157, filed August 17, 2000; and U.S. Patent No. 6,795,807, issued on September 21, 2004.

### BACKGROUND

Artificial speech can be used to generate human speech from one or more inputs (e.g., written text, in response to a received spoken command, etc.). Artificial speech may be used to replace actual speech in a variety of contexts. For example, artificial speech may be used to generate spoken outputs so that text (e.g., text displayed on a screen) may be communicated to a visually impaired individual who could not otherwise read the text. Similarly, artificial speech may allow an individual with a speech impairment (e.g., an individual with amyotrophic lateral sclerosis (ALS); a laryngeally impaired individual, such as a laryngectomee; an individual who is hoarse; an individual with a speech disorder; etc.) to communicate with another individual when they would otherwise be unable to. Likewise, artificial speech may allow an individual who communicates using specific terminology (e.g., in a certain language) to effectively communicate with another individual who is not fluent in that terminology (e.g., by translating from one language to another). Artificial speech, therefore, is broadly applicable to a number of fields and may be used for a number of purposes.

Additionally, machine learning is a field of computing that is widely used across a variety of technical fields. In machine learning, a model is trained using one or more sets of "training data." The training of the machine-learned model may take place in a supervised fashion (i.e., "supervised learning"), an unsupervised fashion (i.e., "unsupervised learning"), or in a semi-supervised fashion (i.e., "semi-supervised learning") depending on whether the training data is labeled with a specified classification. After feeding training data into a machine-learning training algorithm, a machine-learned model be output by the machine-learning algorithm.

The trained machine-learned model may then be applied to a set of "test data" in order to generate an output. In this way, the trained machine-learned model may be applied to new data for which an output is not yet known. For example, a machine-learned model may include a classifier that is trained to determine whether an image includes a human in the image or an animal. The machine-learned model may have been trained using labeled images of humans and labeled images of animals. Thereafter, in runtime, a new image (where it is unknown whether the new image includes a human or an animal) may be input into the machine-learned model in order to determine whether the image includes a human or an animal. Using the machine-learned model to make a prediction about test data is sometimes referred to as the "inference stage."

There exist a variety of types of machine-learned models. Each of the different types of machine-learned model may be used in various contexts in light of the strengths and weaknesses of each. One popular machine-learned model is an artificial neural network (ANN), which includes layers of artificial neurons. The layers of artificial neurons in an ANN are trained to identify certain features of an input (e.g., an input image, an input sound file, or an input text file). Each artificial neuron layer may be built upon sub-layers that are trained to identify sub-features of a given feature. ANNs having many neuron layers are sometimes referred to as "deep neural networks."

### SUMMARY

The specification and drawings disclose embodiments that relate to devices for real-time speech output with improved intelligibility.

In a first aspect, the disclosure describes a device. The device includes a microphone configured to capture one or more frames of unintelligible speech from a user. The device also includes an analog-to-digital converter (ADC) configured to convert the one or more captured frames of unintelligible speech into a digital representation. In addition, the device includes a computing device. The computing device is configured to receive the digital representation from the ADC. The computing device is also configured to apply a machine-learned model to the digital representation to generate one or more frames with improved intelligibility. Further, the computing device is configured to output the one or more frames with improved intelligibility. Additionally, the device includes a digital-to-analog converter (DAC) configured to convert the one or more frames with improved intelligibility into an analog form. Still further, the device includes a speaker configured to produce sound based on the analog form of the one or more frames with improved intelligibility.

In a second aspect, the disclosure describes a method. The method includes capturing, by a microphone, one or more frames of unintelligible speech from a user. The method also includes converting, by an analog-to-digital converter (ADC), the one or more captured frames of unintelligible speech into a digital representation. In addition, the method includes receiving, by a computing device from the ADC, the digital representation. Further, the method includes applying, by the computing device, a machine-learned model to the digital representation to generate one or more frames with improved intelligibility. Additionally, the method includes outputting, by the computing device, the one or more frames with improved intelligibility. Yet further, the method includes converting, by a digital-to-analog converter (DAC), the one or more frames with improved intelligibility into an analog form. Even further, the method includes producing, by a speaker, sound based on the analog form of the one or more frames with improved intelligibility.

In a third aspect, the disclosure describes a non-transitory, computer-readable medium having instructions stored thereon. The instructions, when executed by a processor, cause the processor to execute a method. The method includes receiving a digital representation from an analog-to-digital converter (ADC). The digital representation was generated by the ADC from one or more frames of unintelligible speech from a user that were captured by a microphone. The method also includes applying a machine-learned model to the digital representation to generate one or more frames with improved intelligibility. In addition, the method includes outputting the one or more frames with improved intelligibility to a digital-to-analog converter (DAC). The DAC is configured to convert the one or more frames with improved intelligibility into an analog form. The DAC is also configured to output the analog form to a speaker that is configured to produce sound based on the analog form.

The foregoing summary is illustrative only and is not intended to be in any way limiting. In addition to the illustrative aspects, embodiments, and features described above, further aspects, embodiments, and features will become apparent by reference to the figures and the following detailed description.

### BRIEF DESCRIPTION OF THE FIGURES

Figure 1A is an illustration of a user interacting with a device for real-time speech output with improved intelligibility, according to example embodiments.
Figure 1B is a schematic illustration of a device for real-time speech output with improved intelligibility, according to example embodiments.
Figure 1C is a schematic illustration of a computing device, according to example embodiments.
Figure 2 is a flowchart illustration a method of generating an output with improved intelligibility using a device for real-time speech output with improved intelligibility, according to example embodiments.
Figure 3A is an illustration of a method for training a machine-learned model, according to example embodiments.
Figure 3B is an illustration of a method of making a prediction using a machine-learned model, according to example embodiments.
Figure 4A is an illustration of a generator of a machine-learned model, according to example embodiments.
Figure 4B is an illustration of a discriminator of a machine-learned model, according to example embodiments.
Figure 5 is a flowchart diagram of a method, according to example embodiments.

### DETAILED DESCRIPTION

Example methods and systems are described herein. Any example embodiment or feature described herein is not necessarily to be construed as preferred or advantageous over other embodiments or features. The example embodiments described herein are not meant to be limiting. It will be readily understood that certain aspects of the disclosed systems and methods can be arranged and combined in a wide variety of different configurations, all of which are contemplated herein.

Furthermore, the particular arrangements shown in the figures should not be viewed as limiting. It should be understood that other embodiments might include more or less of each element shown in a given figure. In addition, some of the illustrated elements may be combined or omitted. Similarly, an example embodiment may include elements that are not illustrated in the figures.

Throughout this disclosure, the phrases "unintelligible speech," "snippet of unintelligible speech," "frames of unintelligible speech," "sound corresponding to unintelligible speech," etc. may be used. It is understood that these terms are to be construed broadly and are primarily used to contrast with phrases like "speech with improved intelligibility," "snippet of speech with improved intelligibility," "frames of speech with improved intelligibility," etc. As such, a phrase such as "unintelligible speech" does not necessarily connote that the speech would not or could be understood at all by any listener. Instead, the phrase "unintelligible speech" is merely meant to describe speech which may be improved using the devices and methods herein. Said a different way, while the devices and methods herein may transform "unintelligible speech" to "speech with improved intelligibility," that does not necessarily mean that the "unintelligible speech" was necessarily completely incomprehensible to begin with. Thus, the phrase "unintelligible speech" may sometimes be used as a stand-in, where context dictates, for something akin to "speech with low intelligibility," "speech which is difficult, but not impossible, to parse," "speech that is difficult to understand," etc.

### I. Overview

There have been attempts in the past to improve impaired speech (e.g., for laryngectomees) using artificial speech techniques. It has proven difficult, however, to capture sufficient information about the specific speaker in order to recreate their own voice. In some cases, devices may be used to create a simulated glottal pulse. Such devices may include a manual ability to change frequency. Further, a small loudspeaker may be mounted in the mouth of an individual with impaired speech (e.g., on a denture of the individual) in order to provide for artificial speech. Additionally, some devices may vibrate the neck (e.g., in a controllable way so as to enable the user to change the pitch of the generated speech manually). Such alternative devices, however, may sound overly mechanical / unnatural. Even when a user manually changes the pitch, the sound produced may still not sound similar to the natural sound of the human being.

Various methods for alaryngeal speech enhancement (ASE) have been proposed (e.g., vector quantization and linear multivariate regression for parallel spectral conversion, the use of an air-pressure sensor to control F₀ contours in addition to Gaussian mixture model based voice conversion, one-to-many eigenvoice conversion for ASE, a hybrid approach combining spectral subtraction with eigenvoice conversion, etc.). Many of these techniques include statistical voice conversion methods based on Gaussian mixture models that were subject to over-smoothing in the converted spectra, though, which results in murky-sounding speech. The field of machine-learning has also attempted to be used to address artificial speech. For example, deep neural network-based voice conversion for ASE has been proposed, but such techniques are also subject to over-smoothing. However, generative adversarial network (GAN)-based voice conversion might not suffer from the over-smoothing problem because GAN-based voice conversion may be capable of learning the gradients of the source and target speech distributions. As such, voice-conversion and speech-enhancement GANs may improve speech for both speakers exhibiting one or more speech impairments (e.g., ASE) and speakers without one or more speech impairments.

Example embodiments herein includes devices and methods used to produce artificial speech from one or more snippets of unintelligible speech. The artificial speech output from devices herein may exhibit improved prosody and/or intelligibility when compared with the alternative techniques described above. Further, and crucially, the techniques described herein may allow for the conversion from snippets of unintelligible speech to snippets with improved intelligibility in "real-time" (e.g., less than about 50 ms, less than about 45 ms, less than about 35 ms, less than about 30 ms, less than about 25 ms, less than about 20 ms, less than about 15 ms, less than about 10 ms, etc.). Being able to reproduce artificial speech in real-time may enhance communication in a variety of ways. For example, eliminating delays between the conversion from unintelligible input to intelligible output may prevent adverse feedback effects on the speaker (e.g., due to a delay between the time at which they speak and when they hear themselves speak), may allow conversation to flow more naturally (e.g., when one speaker interjects into a conversation, another speaker can more quickly identify that such an interjection is occurring, which prevents speakers from speaking over one another), etc. In order to perform conversions in "real-time," example embodiments described herein may include one or more computing devices (e.g., with one or more processors therein) that apply one or more machine-learned models in order to generate outputs with improved intelligibility. For example, a GAN may be applied to the snippet of unintelligible speech in order to generate the output with improved intelligibility.

The devices and methods described herein may be used to produce artificial speech with improved intelligibility for users with a variety of speech impairments (e.g., users with ALS, users who can only produce alaryngeal speech due to a laryngectomy, etc.). However, example embodiments may also to enhance intelligibility in other contexts (e.g., to improve intelligibility when a speaker has a strong accent or a particular dialect with which the listener is not familiar).

Some embodiments described herein include devices used to capture an input speech from a user, transform the input speech into speech with greater intelligibility, and then output the speech with greater intelligibility. Such devices may include a microphone, an analog-to-digital converter (ADC), a computing device, a digital-to-analog converter (DAC), an amplifier, and/or a speaker. For example, a device may include a microphone or other input device configured to capture a snippet (e.g., a frame or a series of frames) of unintelligible speech from a user. The snippet of unintelligible speech may then be sent to an ADC in order to convert the snippet of unintelligible speech into a digital form. In some embodiments, the digital form may include a mel-spectrogram (e.g., generated using a Fourier transform of the input snippet). Next, the digital form of the unintelligible speech may be transferred to a computing device for processing. Thereafter, the computing device (e.g., a processor of the computing device executing instructions stored within one or more memories of the computing device) may apply a machine-learned model (e.g., a GAN) to the digital form of the snippet of unintelligible speech in order to produce a snippet with improved intelligibility. The output of the machine-learned model may be provided in a similar form to the input. For example, the machine-learned model may be used to transform a mel-spectrogram with lower intelligibility into a mel-spectrogram with improved intelligibility. The output snippet with improved intelligibility (e.g., in a digital form) may be transferred from the computing device to a DAC (e.g., a DAC that includes a vocoder), where the output snippet is then converted to an analog form. The analog signal corresponding to the analog form of the output snippet with improved intelligibility may then be sent to an amplifier to amplify the analog signal. Finally, the amplified signal may be emitted into the surrounding environment using a speaker. As mentioned above, this entire process may occur in real-time. In this way, speech with enhanced intelligibility can be communicated rapidly.

As is illustrated based on the description above, example embodiments are configured to create alaryngeal speech enhancement (ASE) using one or more GANs. Such enhancement may occur using one-to-one, voice-unpaired conversions. In order to obtain training data to train the machine-learning models described herein (e.g., GANs), recordings from various example users may be captured. For example, both male and female laryngectomees capable of tracheo-esophageal puncture (TEP) speech, electronic larynx speech, and esophageal speech may be recorded (e.g., via one or more lavalier microphones using a web interface). For instance, example users may hold one or more microphones close to their lips to lessen mechanical noise (e.g., in the case of electronic larynx speech or esophageal speech) and be provided with prompts (e.g., 50 prompts) that they attempt to reproduce (e.g., randomly selected from one or more speech datasets, such as the ARCTIC dataset ("CMU ARCTIC databases for speech synthesis;" John Kominek, et al.; published in 2003) or the VCTK dataset ("CSTR VCTK Corpus: English Multi-speaker Corpus for CSTR Voice Cloning Toolkit;" Junichi Yamagishi, et al.; The Centre for Speech Technology Research University of Edinburgh; November 13, 2019)). The speakers' attempted reproductions may be recorded for use as training data. Additionally or alternatively, pre-operative recordings (e.g., prior to a laryngectomy) may be used to train the model (e.g., to train one or more discriminators in the case of a machine-learned model that includes a GAN). Some of the sample users may also be capable of multiple types of speech (e.g., both electronic larynx speech and esophageal speech). As such, multiple recordings of a single user using different types of speech may be captured.

As described herein, the machine-learned model may be trained to perform non-parallel voice conversion. Such a conversion can be reframed as an unpaired image-to-image translation that uses mel-spectrograms in place of images. For example, when using one or more GANs, one or more generators G may learn a mapping from the source speaker distribution, X, to the target speaker distribution, Y, such that G(X) is indistinguishable Y to one or more discriminators D. One example unpaired image-to-image translation GAN technique is CycleGAN ("Unpaired Image-to-Image Translation using Cycle-Consistent Adversarial Networks;" Jun-Yan Zhu, et al.; arXiv:1703.10593; originally published on March 30, 2017), which employs an inverse mapping, F(Y), and an associated cycle consistency loss such that F(G(X)). Example embodiments described herein could be implemented using CycleGAN, for example.

As described above, example embodiments represent improvements over alternative solutions because the conversion is done in real-time. For example, speech systems that operate in a sequential manner do not create prosody until an entire sentence is divided into elements of speech such as words and phonemes. Such schemes may rely on pre-programmed templates to create prosody. Use of pre-programmed templates might not be applicable in a real-time recreation of speech because such schemes may require an understanding of the word and context to be applied (e.g., thereby preventing the ability for real-time output, since the speaking of many sentences, phrases, or even words occur over much longer timescales than "real-time").

### II. Example Embodiments

The following description and accompanying drawings will elucidate features of various example embodiments. The embodiments provided are by way of example, and are not intended to be limiting. As such, the dimensions of the drawings are not necessarily to scale.

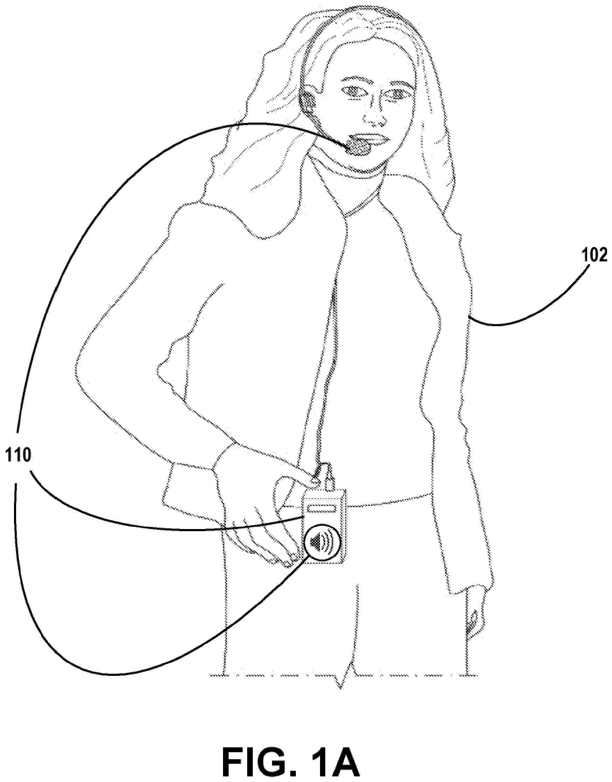

Figure 1A is an illustration of a user 102 interacting with a device for real-time speech output with improved intelligibility 110 (i.e., a speech-improvement device 110). The user may suffer from one or more conditions that necessitate artificial speech in order to effectively or efficiently communicate with another person. For example, the user 102 may be a person suffering from ALS or may have undergone a laryngectomy. For example, the user 102 may have an artificial larynx (e.g., electronic larynx) or a TEP that allows the user 102 to speak and/or may speak using esophageal speech. Such speech, however, may be difficult to understand. In other embodiments, the user 102 may exhibit one or more speech types or patterns that present a challenge to communication (e.g., a heavy accent that is tough for others to understand). As such, the user 102 may use the speech-improvement device 110 to allow the user 102 to generate artificial speech or to enhance the speech that would otherwise be produced by the user 102.

As described herein, the speech-improvement device 110 may use a machine-learned model in order to reproduce an artificial voice that sounds similar to a voice of the user 102 prior to the user 102 developing one or more conditions (e.g., ALS) and/or prior to the user 102 experiencing one or more speech impairments (e.g., as a result of a laryngectomy). Further, the speech-improvement device 110 may allow the user 102 to readily alter the prosody of the artificial speech (e.g., using the machine-learned model) in order to convey calmness, levity, anger, friendship, authority, etc. through the timbre of their voice.

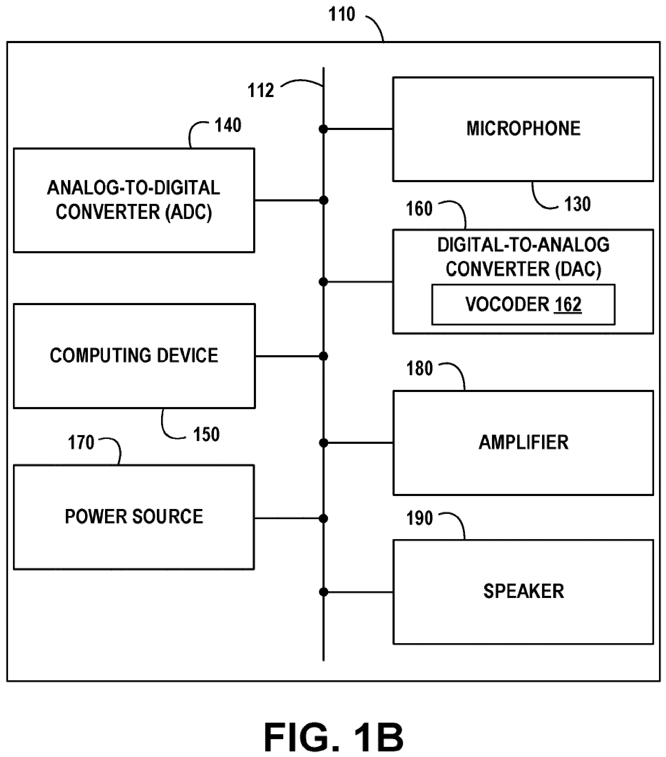

Figure 1B is an illustration of a device for real-time speech output with improved intelligibility (e.g., the speech-improvement device 110 illustrated and described within reference to Figure 1A). It is understood that a speech-improvement device may include many different components across different embodiments, and that the example speech-improvement device 110 shown in Figure 1B is provided solely as an example. As illustrated, the speech-improvement device 110 may include a microphone 130, an ADC 140, a computing device 150, a DAC 160 (e.g., which itself may include a vocoder 162), a power source 170, an amplifier 180, and a speaker 190. As illustrated in Figure 1A, one or more portions of the speech-improvement device 110 may be encapsulated in a housing (e.g., a plastic housing) and worn on a belt, pocket, or other element of clothing of the user 102. In general, and as described in more detail below, the speech-improvement device 110 may be configured to carry out the following functions: capture a snippet of unintelligible speech, convert the snippet from an analog signal to a digital signal, analyze the converted signal using a computing device that may incorporate one or more machine-learned models in order to generate a signal with improved intelligibility, convert the signal with improved intelligibility from a digital signal to an analog signal, and output the analog signal with improved intelligibility (e.g., by playing the analog signal with improved intelligibility through a speaker).

Each of the components of the speech-improvement device 110 may communicate with one or more other components within the speech-improvement device 110 using one or more communication interfaces 112. For example, the communication interfaces may include one or more wireless communication protocols (e.g., IEEE 802.15.1 - BLUETOOTH^{®}, IEEE 802.11 - WIFI^{®}, radio-frequency communication, infrared communication, etc.) and/or one or more wired protocols (e.g., ETHERNET, Universal Serial Bus (USB), communication via traces on a printed circuit board (PCB), communication over optical fiber, etc.). In some embodiments, as illustrated, the communication interface 112 of the speech-improvement device 110 may be a single communication interface 112 through which each component of the speech-improvement device 110 is interconnected and can communicate with other components of the speech-improvement device 110. In other embodiments, however, separate communication channels may be used to interconnect various components of the speech-improvement device 110. For example, the microphone 130 may be connected wirelessly to the ADC 140 using BLUETOOTH^{®}, but the ADC 140 may be connected to the computing device 150 over a USB connection. Other communication types are also possible and are contemplated herein.

Further, in some embodiments, there may be multiple copies of one or more of the components and/or one or more of the components may be integrated into (or not integrated into) one of the other components in a different way than is illustrated. For example, in some embodiments there may be multiple (e.g., and different types of) power sources. For example, the speaker 190 and/or the microphone 130 may have a different power source 170 than the computing device 150. Additionally, the vocoder 162 may not be integrated into the DAC 160 in some embodiments, but instead a standalone component or integrated into the computing device 150, among other possibilities. In still other embodiments, the amplifier 180 could be integrated into the computing device 150 or into the speaker 190. Still further, one or more of the components of the speech-improvement device 110 may not be physically connected to one or more of the other components of the speech-improvement device 110 (e.g., the microphone 130 may be located remotely from the other components of the speech-improvement device 110 and connected by BLUETOOTH^{®}). Lastly, in some embodiments, the speech-improvement device 110 may not include all of the components illustrated in Figure 1B. For example, in some embodiments, the speech-improvement device 110 may generate improved artificial speech and store the improved artificial speech within the computing device 150 or transmit the improved artificial speech to another device (e.g., for output or storage) rather than outputting the improved artificial speech itself (e.g., using the speaker 190). In such embodiments, the speech-improvement device 110 may not include an amplifier 180 and/or a speaker 190, for example. Other arrangements of the components of the speech-improvement device 110 are also possible and are contemplated herein.

The microphone 130 may include a mechanical device that transduces sound (e.g., variations in air pressure) into a signal (e.g., an electrical signal, such as an electrical signal corresponding to variations in current or voltage over time). The microphone 130 may be used to capture one or more snippets of unintelligible speech. The microphone 130 may capture these snippets in one or more frames. For example, a frame may correspond to a sound recording that is 8 ms - 12 ms in length and a snippet of unintelligible speech may be three frames in length. The length of time for a frame and/or the number of frames in a snippet may be set by the computing device 150 and communicated to the microphone 130, for example. Alternatively, the microphone 130 may continuously capture sound that the computing device 150 later breaks up into frames / snippets in order to analyze. Still further, in some embodiments, the time duration of each frame and/or the number of frames in a snippet may be held constant, while in other embodiments these values may be modulated over time (e.g., by the computing device 150). In various embodiments, the microphone 130 may include a condenser microphone, a dynamic microphone, a ribbon microphone, a piezoelectric microphone, a microelectromechanical systems (MEMS) microphone, etc. In some embodiments, the speech-improvement device 110 may also include one or more user inputs. For example, the speech-improvement device 110 may include one or more buttons, one or more switches, one or more touchscreens, etc. Such user inputs may be used to activate or otherwise control the microphone 130 and/or one or more other components of the speech-improvement device 110 (e.g., the computing device 150). For example, a button may be pressed by a user to begin capturing unintelligible speech from the user (e.g., by powering on the microphone). In such a way, energy (e.g., stored within a battery of the power source 170) can be conserved by refraining from powering / running the device when a user is not presently talking. Additionally or alternatively, unintelligible speech that was previously captured (e.g., and stored within a memory of the speech-improvement device 110) may be selected for improvement. For example, a selection of a snippet of unintelligible speech from among a group of snippets may be made via a user interface.

Additionally or alternatively, in some embodiments, the microphone 130 may be replaced by another device that includes multiple or alternative input devices. For example, if the user 102 has undergone a laryngectomy, the microphone 130 may be replaced by a neck vibrator / microphone combination that assists the user 102 in generating sound waves using the neck vibrator (e.g., to simulate a glottal pulse) and then detects the generated sound waves using a microphone. In such embodiments, the neck vibrator / microphone combination may include a transmitter (e.g., a radio-frequency transmitter) that communicates with the computing device 150 in order to provide information to the computing device 150 about a frequency and/or timing of the vibration used by the neck vibrator in order to assist in the generation of sound. Likewise, the microphone 130 may be replaced or augmented by an eye-gaze input device (e.g., when the user 102 suffers from ALS). Upon capturing the one or more snippets of unintelligible speech, the microphone 130 may communicate an analog signal corresponding to the one or more snippets of unintelligible speech to one or more other components of the speech-improvement device 110. For example, the microphone 130 may communicate the one or more captured snippets of unintelligible speech to the ADC 140 and/or the computing device 150.

The ADC 140 may be used to convert an analog signal (e.g., an analog signal corresponding to one or more snippets of unintelligible captured by the microphone 130) into a digital signal (e.g., a series of bits that can be analyzed by the computing device 150 and/or stored within a memory of the computing device 150). For example, the ADC 140 may include a 13-bit linear pulse-code modulation (PCM) Codec-Filter (e.g., the MOTOROLA^{®} MC145483). A digital signal produced by the ADC 140 may be encoded and/or compressed (e.g., using a codec) such that it can be more readily analyzed by the computing device 150. For example, the digital signal may be converted to and/or stored (e.g., within a memory of the computing device 150) as a .MP3 file, a .WAV file, a .AAC file, or a .AIFF file.

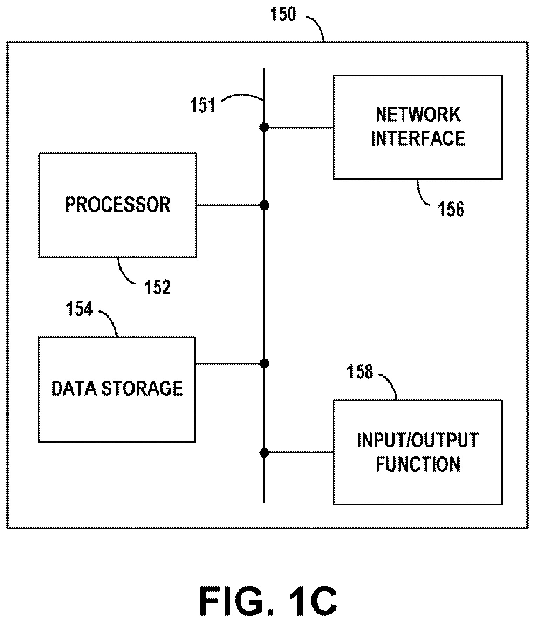

The computing device 150 may be used to generate a signal (e.g., a digital signal) with improved intelligibility based on an input from the microphone 130 that corresponds to a snippet of unintelligible speech (e.g., based on a digital representation of the snippet of unintelligible speech received from the ADC 140). In some embodiments, the computing device 150 may include an NVIDIA^{®} JETSON NANO^{®}. The JETSON NANO^{®} may consume relatively little power during operation (e.g., thereby making the computing device 150, and the corresponding speech-improvement device 110 as a whole, relatively portable). The JETSON NANO^{®} may also contain the software and adequate random-access memory (RAM) for performing calculations in real-time. In one example, the computing device 150 may transmit a signal (e.g., a radio-frequency signal) to a vibrator of an electronic larynx to generate a glottal pulse. In various embodiments, the computing device 150 may include a variety of components (e.g., one or more processors, one or more memories, etc.). An example embodiment of the computing device 150 is shown and described with reference to Figure 1C.

Figure 1C is a simplified block diagram that illustrates an example computing device (e.g., the computing device 150 illustrated and described above with respect to Figure 1B). As illustrated, the computing device 150 includes a processor 152, a data storage 154, a network interface 156, and an input/output function 158, all of which may be interconnected using a system bus 151 or other communication interface.

The processor 152 may be a central processing unit (CPU), in some embodiments. As such, the processor 152 may include one or more segments of on-board memory (e.g., one or more segments of volatile memory, such as one or more caches). Additionally or alternatively, the processor 152 may include one or more general purpose processors and/or one or more dedicated processors (e.g., application specific integrated circuits (ASICs), digital signal processors (DSPs), graphics processing units (GPUs), tensor processing units (TPUs), network processors, etc.). For example, the processor 152 may include a DSP configured to convert a digital signal (e.g., received by the computing device 150 from the ADC 140) corresponding to the one or more snippets of unintelligible speech (e.g., as captured by the microphone 130) into a mel-spectrogram or some other representation in the frequency domain. The processor 152 may also be configured to (e.g., when executing instructions stored within the data storage 154) apply a machine-learned model to the mel-spectrogram / other representation in the frequency domain in order to provide frequency information, to provide volume information, and/or to generate a digital signal having improved intelligibility.

The data storage 154 may include volatile and/or non-volatile data storage devices (e.g., a non-transitory, computer-readable medium) and can be integrated in whole or in part with the processor 152. The data storage 154 may contain executable program instructions (e.g., executable by the processor 152) and/or data that may be manipulated by such program instructions to carry out the various methods, processes, or operations described herein. Alternatively, these methods, processes, or operations can be defined by hardware, firmware, and/or any combination of hardware, firmware, and software. In some embodiments, the data storage 154 may include a read-only memory (ROM) and/or a random-access memory (RAM). For example, the data storage 154 may include a hard drive (e.g., hard disk), flash memory, a solid-state drive (SSD), electrically erasable programmable read-only memory (EEPROM), dynamic random-access memory (DRAM), and/or static random-access memory (SRAM). It will be understood that other types of volatile or non-volatile data storage devices are possible and contemplated herein.

The network interface 156 may take the form of a wired connection (e.g., an ETHERNET connection) or a wireless connection (e.g., BLUETOOTH^{®} or WIFI^{®} connection). However, other forms of physical layer connections and other types of standard or proprietary communication protocols may be used over the network interface 156. Furthermore, the network interface 156 may include multiple physical interfaces. The network interface 156 may allow the computing device 150 to communicate with one or more devices (e.g., devices that are separate from the speech-improvement device 110). For example, the computing device 150 may communicate with an external server (e.g., over the public Internet) in order to retrieve updated firmware (e.g., which may include an improvement to the machine-learned model used by the processor 152 to generate signals having improved intelligibility) and/or store data (e.g., data captured by the microphone 130 of the speech-improvement device 110).

The input/output function 158 may facilitate interaction (e.g., using USB, WIFI^{®}, radio-frequency, ETHERNET, etc.) between the computing device 150 (e.g., the processor 152 of the computing device 150) and other components of the speech-improvement device 110. For example, the input/output function 158 may allow the ADC 140 to provide digital signals corresponding to snippets of unintelligible speech to the computing device 150 for analysis and/or may allow the computing device 150 to provide digital signals corresponding to snippets of speech with improved intelligibility to the DAC 160 for eventual output (e.g., by the speaker 190).

The DAC 160 may be configured to convert a digital signal from the computing device 150 (e.g., generated by the computing device 150 by applying one or more machine-learned models to one or more snippets of unintelligible speech) to an analog signal (e.g., an analog signal representing sound). The digital signal from the computing device 150 may be stored in a compressed and/or encoded format. As such, the digital signal may be decompressed and/or decoded prior to the computing device 150 providing the digital signal to the DAC 160. In some embodiments, as illustrated in Figure 1B, the DAC 160 may include a vocoder 162 (e.g., implemented in hardware and/or in software). The vocoder 162 may be configured to translate a voice signal (e.g., a speech signal) from a frequency domain to a time domain. In some embodiments, the vocoder 162 may be configured to convert a mel-spectrogram into an analog signal. Further, the vocoder 162 may include one or more machine-learned models. For example, the vocoder 162 may include a processor configured to apply one or more machine-learned models in order to generate an analog signal. The one or more machine-learned models stored within and/or applied by the vocoder 162 may include one or more ANNs (e.g., one or more GANs, such as a pre-trained Hifi-GAN v1 - *"*HiFi-GAN: Generative Adversarial Networks for Efficient and High Fidelity Speech Synthesis;" Jungil Kong, et al.; arXiv:2010.05646; originally published on October 12, 2020). A digital signal output by the DAC 160 may be ultimately supplied to the amplifier 180 and, subsequently, the speaker 190 for output.

The power source 170 may be configured to provide power to one or more other components of the speech-improvement device 110. In some embodiments, for example, the power source 170 may include a connection to an alternating current (AC) source (e.g., a wall socket) and/or one or more batteries (e.g., rechargeable batteries). The use of batteries in the power source 170 may allow the speech-improvement device 110 to be portable. Further, in some embodiments, the power source 170 may include a voltage regulator. The voltage regulator may be configured to modulate an input voltage (e.g., the voltage of a battery of the power source 170) to produce one or more appropriate output voltages for use by the other components of the speech-improvement device 110. Further, in embodiments where the power source 170 includes a connection to an AC source, the power source 170 may also include a converter (e.g., including a rectifier) that converts from AC to direct current (DC) to be used by the other components of the speech-improvement device 110.

The amplifier 180 may be configured to take an analog signal (e.g., an analog audio signal) and amplify it (e.g., produce another analog signal having increased magnitude). Thereafter, the speaker 190 may receive the amplified signal from the amplifier 180 and produce an audible using the amplified signal. In some embodiments, the speaker 190 may include an arrangement of multiple speakers within one or more housings (e.g., cabinets). For example, the speaker 190 may include one or more tweeters and/or one or more woofers in order to reproduce a higher dynamic range of frequencies.

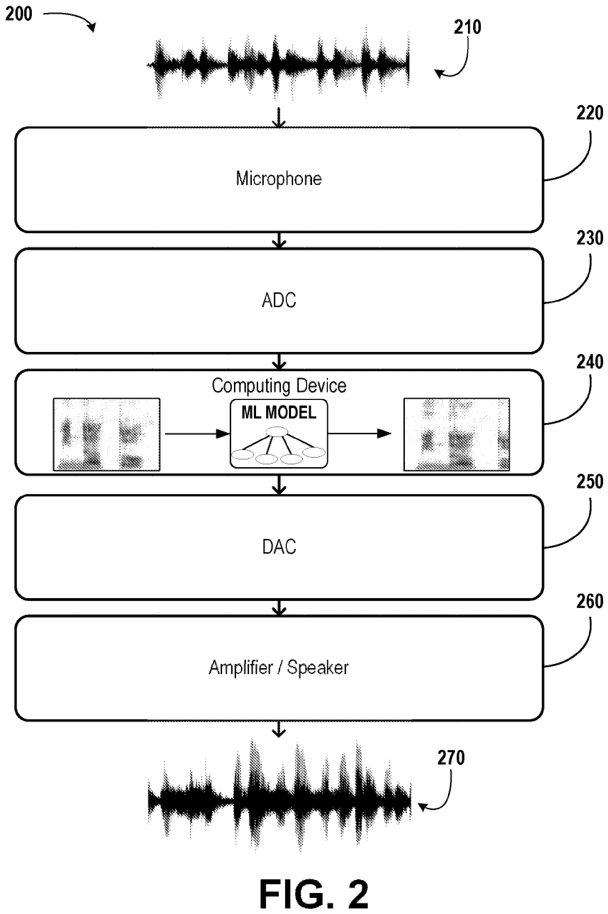

Figure 2 is a flowchart illustration of a method 200 of generating an output with improved intelligibility (e.g., by a user 102 using a speech-improvement device 110 as shown and described with reference to Figures 1A and 1B), according to example embodiments. It is understood that the method 200 of Figure 2 is provided solely as an example and that other methods of converting a snippet of unintelligible speech into a snippet of speech with improved intelligibility are also possible and contemplated herein.

At step 210, the method 200 may include a sound being produced that corresponds to unintelligible speech. Such a sound may be produced by a user (e.g., a user 102 of the speech-improvement device 110). For example, a laryngectomee, a user with ALS, or a user with a heavy accent may produce sound that corresponds to unintelligible speech (e.g., unintelligible as a result of a laryngectomy). It is understood that in other embodiments other sources of unintelligible speech are also possible and are contemplated herein. For example, a loudspeaker (e.g., attached to a television or a radio) may output sound corresponding to unintelligible speech (e.g., during playback of dialog within a movie). Such output sound may be garbled as a result of one or more defects in the loudspeaker, for instance.

At step 220, the method 200 may include a microphone (e.g., the microphone 130 shown and described with reference to Figure 1B) capturing the sound produced in step 210 that corresponds to unintelligible speech. This may sometimes be referred to herein as capturing a "snippet of unintelligible speech." In some embodiments, the snippet of unintelligible speech captured by the microphone may correspond to multiple frames (e.g., two frames, three frames, four frames, five frames, six frames, etc.) of unintelligible speech. Further, the microphone may be configured to capture sound in frames of a specified duration (e.g., about 8 ms, about 10 ms, about 12 ms, or some other value between about 8 ms and about 12 ms). The number of frames captured and/or the length of each frame captured may be determined (e.g., by the computing device 150) based on: an architecture of a machine-learned model (e.g., of a GAN) that is ultimately to be applied in the method 200 and/or based on one or more aspects of the sound captured (e.g., characteristics of the person speaking in order to generate the unintelligible speech). Further, in other embodiments, the microphone may capture a single continuous sound signal corresponding to the unintelligible speech. Such a continuous sound signal may be later broken up (e.g., discretized) into one or more frames of unintelligible speech (e.g., by an ADC 140 or by a computing device 150 of the speech-improvement device 110). At the end of step 220, the sound signal may be passed to an ADC (e.g., the ADC 140 shown and described with reference to Figure 1B).

At step 230, the method 200 may include converting (e.g., by the ADC 140 shown and described with reference to Figure 1B) the signal captured by the microphone in step 220 from an analog signal into a digital representation such that the signal can ultimately be analyzed by a computing device (e.g., the computing device 150 shown and described with reference to Figures 1B and 1C). At the end of step 230, the digital representation of the sound signal may be passed to a computing device (e.g., the computing device 150 shown and described with reference to Figure 1B).

At step 240, the method 200 may include analyzing (e.g., by the computing device 150 shown and described with reference to Figures 1B and 1C) the digital representation from the ADC. For example, the processor 152 of the computing device 150 may execute instructions stored within the data storage 154 of the computing device 150 to apply a machine-learned model (e.g., a GAN, as described further below) to the digital representation of the unintelligible speech in order to generate a digital representation of speech with improved intelligibility. As illustrated in Figure 2, step 240 may include the computing device converting the digital representation from the ADC into a mel-spectrogram and then applying the machine-learned model to produce another mel-spectrogram (e.g., representing improved intelligibility). For example, the machine-learned model may output one or more frames with improved intelligibility in the form of a mel-spectrogram. A mel-spectrogram is an image that represents the frequency spectrum of a snippet (e.g., frame) of sound (e.g., using an intensity indicator, such as color / brightness within the image, to illustrate intensities at various times for various frequencies). For example, the mel-spectrogram may be computed based on the digital representation from the ADC by taking a Fourier transform of the digital representation and then scaling to the mel scale (e.g., the scale factor used to account for human-audible frequencies). While, in some embodiments, a mel-spectrogram may be generated / fed into the machine-learned model, it is understood that other embodiments are also possible and contemplated herein. For example, a digital sound file may be fed directly into the machine-learned model in order to produce an output digital sound file representing speech with improved intelligibility. In some embodiments, which type of input to the machine-learned model is used may depend on how the machine-learned model was trained during a training phase (e.g., what type of training data was used to train the machine-learned model). At the end of step 240, the digital representation of the sound signal with improved intelligibility may be passed to a DAC (e.g., the DAC 160 shown and described with reference to Figure 1B).

At step 250, the method 200 may include inverting the digital representation (e.g., the mel-spectrogram) from the computing device to produce an analog signal that can be used to produce sound. For example, the DAC 160 may invert the mel-spectrogram with improved intelligibility to generate an electrical signal (e.g., representing speech with improved intelligibility). Such an inversion may be performed by a vocoder (e.g., the vocoder 162) of the DAC 160, for instance. In some embodiments, the vocoder 162 may include (e.g., stored within a memory of the vocoder 162) a machine-learned model that is trained to invert mel-spectrograms into waveforms. For example, such a machine-learned model may include one or more GANs. At the end of step 250, the analog signal produced by the DAC may be passed to an amplifier (e.g., the amplifier 180 shown and described with reference to Figure 1B).

At step 260, the method 200 may include amplifying the signal from the DAC and providing the amplified signal to a speaker (e.g., the speaker 190 shown and described with reference to Figure 1B). Upon receiving the amplified signal, the speaker may produce sound 270 that corresponds artificial speech with improved intelligibility.

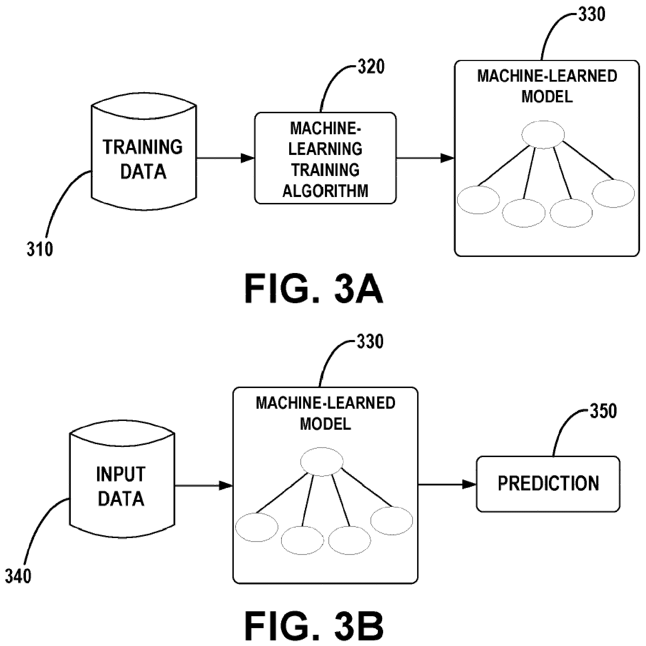

Figure 3A illustrates a method of training a machine-learned model 330 (e.g., an ANN, such as a GAN), according to example embodiments. The method of Figure 3A may be performed by a computing device (e.g., the computing device 150 illustrated in Figure 1C or a different computing device), in some embodiments. As illustrated, the machine-learned model 330 may be trained using a machine-learning training algorithm 320 based on training data 310 (e.g., based on patterns within the training data 310). While only one machine-learned model 330 is illustrated in Figures 3A and 3B, it is understood that multiple machine-learned models could be trained simultaneously and/or sequentially and used to perform the predictions described herein. For example, in the case of a GAN, one or more generators and one or more discriminators could be simultaneously trained. Ultimately, a prediction 350 may be made using the trained machine-learned model 330 (e.g., by one or more generators of a GAN). For example, the machine-learned model 330 may be used (e.g., by the computing device 150) to generate a snippet of sound with improved intelligibility (e.g., based on the snippet of unintelligible speech captured by the microphone 130).

The machine-learned model 330 may include, but is not limited to: one or more ANNs (e.g., one or more convolutional neural networks, one or more recurrent neural networks, one or more Bayesian networks, one or more hidden Markov models, one or more Markov decision processes, one or more logistic regression functions, one or more suitable statistical machine-learning algorithms, one or more heuristic machine-learning systems, one or more GANs, etc.), one or more support vector machines, one or more regression trees, one or more ensembles of regression trees (i.e., regression forests), one or more decision trees, one or more ensembles of decision trees (i.e., decision forests), and/or some other machine-learning model architecture or combination of architectures. Regardless of the architecture used, the machine-learned model 330 may be trained to clarify consonants and/or vowels, to determine and/or enhance prosody, and/or to reconstruct a natural glottal pulse. For example, in the case of a GAN, one or more generators of the GAN may take an input signal (e.g., a digital version of a signal having low intelligibility captured from a user via a microphone) and produce an output signal (e.g., a digital version of a signal having higher intelligibility) by improving the consonant sounds, vowel sounds, prosody, and/or glottal pulse of the input signal.

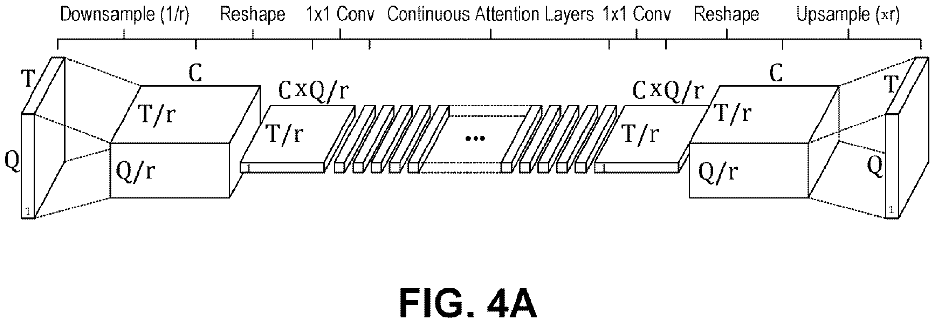

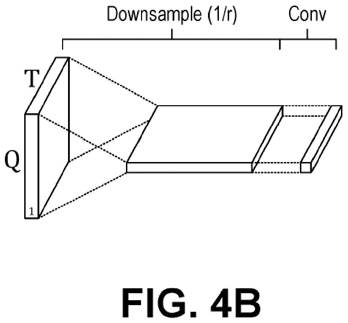

As one example and as described herein, the machine-learned model 330 may include a GAN that, once trained, is configured to take one or more snippets of unintelligible speech (e.g., in a digital form, such as a sound file or a mel-spectrogram) and convert them into one or more snippets of speech with improved intelligibility (e.g., in a digital form, such as a sound file or a mel-spectrogram) that can be output (e.g., by a speaker upon the digital form being converted into an analog sound signal). It is understood that a variety of GAN architectures can be employed within embodiments herein. For example, the GANs described in CycleGAN-VC2 ("CycleGAN-VC2: Improved CycleGAN-based Non-parallel Voice Conversion;" Takuhiro Kaneko, et al.; arXiv:1904.04631; originally published on April 9, 2019) and CycleGAN-VC3 ("CycleGAN-VC3: Examining and Improving CycleGAN- VCsfor Mel-spectrogram Conversion;" Takuhiro Kaneko, et al.; arXiv:2010.11672; originally published on October 22, 2020) could be employed. In some embodiments, and as described further with reference to Figures 4A and 4B, modifications may be made to the CycleGAN-VC2 and CycleGAN-VC3 architectures to provide further augmentation when generating outputs with improved intelligibility using example devices as described herein.

Other potential GAN architectures may include those described in ConvS2S-VC ("ConvS2S-VC: Fully convolutional sequence-to-sequence voice conversion;" Hirokazu Kameoka, et al.; arXiv:1811.01609; originally published on November 8, 2018), Gaussian mixture model-based (GMM-based) voice conversion (VC) using sprocket ("sprocket: Open-Source Voice Conversion Software;" Kazuhiro Kobayashi, et al.; Proc. Odyssey, pp. 203-210; June 2018), StarGAN-VC ("StarGAN-VC: Nonparallel many-to-many voice conversion with star generative adversarial networks;" Hirokazu Kameoka, et al.; arXiv:1806.02169; originally published on June 6, 2018), AutoVC ("AUTOVC: Zero-Shot Voice Style Transfer with Only Autoencoder Loss;" Kaizhi Qian, et al.; arXiv:1905.05879; originally published on May 14, 2019), and cascaded automatic speech recognition / text-to-speech (ASR-TTS) models ("On Prosody Modeling for ASR+TTS based Voice Conversion;" Wen-Chin Huang, et al.; arXiv:2107.09477; originally published on July 20, 2021). However, when applied to improving the intelligibility of input snippets related to certain users (e.g., users with ALS or users who had undergone a laryngectomy), such architectures may fail to converge when attempting to generate an output using the one or more generators and/or may provide outputs with lower intelligibility or lower prosody compared to the examples illustrated and described with reference to Figures 4A and 4B.

The machine-learning training algorithm 320 may involve supervised learning, semi-supervised learning, reinforcement learning, and/or unsupervised learning. Similarly, the training data 310 may include labeled training data and/or unlabeled training data. Further, similar to described above with respect to the machine-learned model 330, a number of different machine-learning training algorithms 320 could be employed herein. If the machine-learned model 330 includes a GAN, the machine-learning training algorithm 320 may include training one or more discriminator ANNs and one or more generator ANNs based on the training data 310. The discriminator(s) may be trained to distinguish between snippets / signals (e.g., in a digital form such as a mel-spectrogram) with acceptable intelligibility (e.g., actual captured voices) and snippets / signals (e.g., in a digital form such as a mel-spectrogram) with inadequate intelligibility (e.g., garbled signals or signals indicating a heavy accent). The one or more generators, on the other hand, may be trained to produce, based on an input snippet, an output snippet / signal (e.g., in a digital form such as a mel-spectrogram) that fools the discriminator(s) (i.e., a snippet / signal for which the discriminator(s) cannot determine whether the snippet / signal has acceptable intelligibility or inadequate intelligibility). In other words, the one or more generators G may generate an output Y when applied to an input X (i.e., G(X) = Y) and the discriminator(s) may be configured to attempt to apply a further function D to the output of the one or more generators Y to attempt to determine whether output Z (i.e., D(Y) = Z) is proper (e.g., whether Z is a snippet / signal with acceptable intelligibility). An example generator is illustrated and described with reference to Figure 4A. Likewise, an example discriminator is illustrated and described with reference to Figure 4B.

Additionally, the machine-learning training algorithm 320 may be tailored and/or altered based on the machine-learned model 330 to be generated (e.g., based on desired characteristics of the output machine-learned model 330). For example, when the machine-learned model 330 includes a GAN, the machine-learning training algorithm 320 may include applying two-step adversarial losses (*L_{adv2}* (*G_{Y2X}, G_{XYY}, D*') and vice versa for Dx'), identity-mapping losses, cycle-consistency losses, etc. Such a machine-learning training algorithm 320 may reflect similar training objectives to those undertaken in CycleGAN-VC2 ("CycleGAN-VC2: Improved CycleGAN-based Nonparallel Voice Conversion;" Takuhiro Kaneko, et al.; arXiv:1904.04631; originally published on April 9, 2019) and/or CycleGAN-VC3 ("CycleGAN- VC3: Examining and Improving CycleGAN-VCs for Mel-spectrogram Conversion;" Takuhiro Kaneko, et al.; arXiv:2010.11672; originally published on October 22, 2020). For example, the following types of loss may be used when training the GAN:

The training data 310 may be used to train the machine-learned model 330 using the machine-learning training algorithm 320. For example, the machine-learned model 330 may include labeled training data that is used to train the machine-learned model 330. In embodiments where the machine-learned model 330 includes one or more GANs, the training data 310 may include sound snippets with high intelligibility (e.g., used as an input to train one or more discriminators of a GAN) and/or sound snippets with low intelligibility (e.g., used as an input for training one or more generators of a GAN). For instance, the training data 310 may include calculating, considering, minimizing, and/or maximizing the following:
1. Adversarial loss - discriminator(s) of a GAN may seek to maximize the adversarial loss function in order to distinguish synthesized inputs (e.g., produced by one or more generators) from actual inputs, whereas one or more generators of a GAN may seek to minimize adversarial loss in order to deceive the discriminator(s);
2. Cycle-consistency loss - this loss may be considered to preserve a composition during a conversion (e.g., a hyperparameter may be used to control the relative importance of cycle-consistency loss, as well);
3. Identity-mapping loss - this loss may be considered to preserve inputs (e.g., a hyperparameter may be used to control the relative importance of identity-mapping loss, as well); and
4. Second adversarial loss - in some embodiments, multiple discriminators may be used to mitigate statistical averaging; in such embodiments, a second adversarial loss may be introduced and imposed on circularly converted features.

Further, in some embodiments (e.g., and unlike the training described in CycleGAN-VC2 ("CycleGAN-VC2: Improved CycleGAN-basedNonparallel Voice Conversion;" Takuhiro Kaneko, et al.; arXiv:1904.04631; originally published on April 9, 2019) and/or CycleGAN-VC3 ("CycleGAN-VC3: Examining and Improving CycleGAN-VCs for Mel-spectrogram Conversion;" Takuhiro Kaneko, et al.; arXiv:2010.11672; originally published on October 22, 2020)), the machine-learning training algorithm 320 may include a stop gradient function used to skip updating the discriminator(s) D during a step of the training (e.g., during gradient descent) when the discriminator loss is less than a predetermined threshold (e.g., 0.2). This may prevent mode collapse during training of the discriminator(s) D and stabilize the training of the GAN (e.g., by preventing the one or more discriminators from encouraging the one or more generators to collapse towards minor, unperceivable changes in order to fool the one or more discriminators).

In some embodiments, training the discriminator(s) / generator(s) may occur in a supervised fashion using labeled training data (e.g., sample snippets / signals that are labeled as corresponding to acceptable intelligibility) and/or using sample input training data for the generator(s). Further, in some embodiments, the machine-learning training algorithm 320 may enforce rules during the training of the machine-learned model 330 through the use of one or more hyperparameters.

The training data 310 may be used to train the machine-learned model 330 using the machine-learning training algorithm 320. For example, the machine-learned model 330 may include labeled training data that is used to train the machine-learned model 330. In embodiments where the machine-learned model 330 includes one or more GANs, the training data 310 may include sound snippets with high intelligibility (e.g., used as an input to train one or more discriminators of a GAN) and/or sound snippets with low intelligibility (e.g., used as an input for training one or more generators of a GAN). For instance, the training data 310 may include:
1. one or more recordings or representations (e.g., mel-spectrograms) of natural (e.g., high-intelligibility) speech, which may include a plurality of speech features (e.g., such speech features being: (i) between 20 ms and 60 ms (e.g., 20 ms, 25 ms, 30 ms, 35 ms, 40 ms, 45 ms, 50 ms, 55 ms, or 60 ms) in length; and/or (ii) subsequently organized into discrete clusters upon training the machine-learned model 330 using the training data 310, where the organization is performed using k-means clustering where k is about 100);
2. one or more recordings or representations (e.g., mel-spectrograms) of speech produced by a user suffering from one or more speech impairments (e.g., the user to whom the machine-learned model 330 will be applied in runtime or a different user), such as a user who has undergone a laryngectomy, a user with ALS, etc.;
3. one or more recordings or representations (e.g., mel-spectrograms) of alaryngeal speech (e.g., used as an input to train one or more generators of a GAN), such as a predetermined type of alaryngeal speech (e.g., the type of alaryngeal speech exhibited by the user to whom the machine-learned model 330 will be applied in runtime);
4. one or more recordings or representations (e.g., mel-spectrograms) of one or more sounds from an ARCTIC dataset or VCTK dataset and/or one or more recordings or representations (e.g., mel-spectrograms) of one or more test subjects (e.g., subjects with one or more speech impairments relevant to the user to whom the machine-learned model 330 will be applied in runtime) attempting to reproduce the one or more sounds from the ARCTIC dataset or VCTK dataset (e.g., through alaryngeal speech);
5. one or more recordings or representations (e.g., mel-spectrograms) of speech (e.g., used as an input to train one or more discriminators of a GAN) produced by a user suffering from one or more speech impairments at a time prior to when the user suffered from the one or more speech impairments (e.g., recordings of the user prior to the user undergoing a laryngectomy, such as may be present on an answering machine recording, home video recording, or web-archived video); and/or
6. one or more recordings or representations (e.g., mel-spectrograms) of speech (e.g., used as an input to train one or more discriminators of a GAN) produced by a person having similar characteristics to the user to whom the machine-learned model 330 will be applied in runtime (e.g., a person having the same sex as the user; a person of similar height to the user; a person of similar weight to the user; or a relative of the user, such as a sibling, parent, or child of the user).

Once the machine-learned model 330 is trained by the machine-learning training algorithm 320 (e.g., using the method of Figure 3A), the machine-learned model 330 may be used to make one or more predictions (i.e., inferences). For example, a computing device (e.g., the computing device 150 shown and described with reference to Figures 1B and 1C), may make a prediction 350 using the machine-learned model 330 based on input data 340, as illustrated in Figure 3B (e.g., the machine-learned model 330 may generate a snippet with improved intelligibility based on an input snippet with low intelligibility).

While the same computing device (e.g., the computing device 150 of Figures 1B and 1C) may be used to both train the machine-learned model 330 (e.g., as illustrated in Figure 3A) and make use of the machine-learned model 330 to make a prediction 350 (e.g., as illustrated in Figure 3B), it is understood that this need not be the case. In some embodiments, for example, a computing device may execute the machine-learning training algorithm 320 to train the machine-learned model 330 and may then transmit the machine-learned model 330 to another computing device for use in making one or more predictions 350. In the context of this disclosure, for example, a computing device may be used to initially train the machine-learned model 330 and then this machine-learned model 330 could be stored for later use. For example, the machine-learned model 330 could be trained and then stored within a memory of a computing device 150 of a speech-improvement device 110. Then, the computing device 150 that receives a snippet of unintelligible speech (e.g., as captured by the microphone 130) may simply make use of the machine-learned model 330 to generate an output without having to train the machine-learned model 330.

As described above, example machine-learned models 330 implemented herein (e.g., to generate one or more snippets of speech with improved intelligibility from one or more snippets with lower intelligibility) may include one or more GANs. Such GANs may include one or more generators and one or more discriminators. A generator according to example embodiments is illustrated in Figure 4A. The generator (e.g., a trained neural network) may be somewhat related to the generator architecture of CycleGAN-VC2 ("CycleGAN-VC2: Improved CycleGAN-based Nonparallel Voice Conversion;" Takuhiro Kaneko, et al.; arXiv:1904.04631; originally published on April 9, 2019) and/or CycleGAN-VC3 ("CycleGAN-VC3: Examining and Improving CycleGAN-VCs for Mel-spectrogram Conversion;" Takuhiro Kaneko, et al.; arXiv:2010.11672; originally published on October 22, 2020). For example, the generator may include a two-dimensional / one-dimensional / two-dimensional structure. Further, the generator may include a downsampling portion, a reshaping portion, a 1x1 conversion portion, another 1x1 conversion portion, another reshaping portion, and an upsampling portion (e.g., where the upsampling portion includes a two-dimensional time-frequency adaptive normalization (TFAN) portion). The generators of CycleGAN-VC2 ("CycleGAN-VC2: Improved CycleGAN-based Non-parallel Voice Conversion;" Takuhiro Kaneko, et al.; arXiv: 1904.04631; originally published on April 9, 2019) and/or CycleGAN-VC3 ("CycleGAN- VC3: Examining and Improving CycleGAN-VCs for Mel-spectrogram Conversion;" Takuhiro Kaneko, et al.; arXiv:2010.11672; originally published on October 22, 2020) may include a variety of benefits. For example, such generators may preserve the temporal structure of speech (e.g., across a broad spectrum of temporal relationships) while also reflecting the overall relationship along a direction of features. Further, such generators may include gated linear units (GLUs) that are capable of being trained to identify sequential and hierarchical structure. In addition, the two-dimensional / one-dimensional / two-dimensional structure may maintain sufficient structure through conversion (e.g., by extracting the time-frequency structure while preserving the original structure in the case of two-dimensional portions, as well as performing dynamic changes in the case of one-dimensional portions).

However, unlike the generator architecture of CycleGAN-VC2/VC3, the one-dimensional ResNet blocks (e.g., near a center of the generator) may be replaced with a series of continuous attention layers (e.g., as illustrated in Figure 4A), such as one or more continuous attention layers that use attention with linear biases (ALiBi). Generators that include such continuous attention layers may exhibit improved reproduction of snippets with improved intelligibility when compared to generators that do not include such continuous attention layers. In addition to continuous attention layers, other layers of example generators used herein (e.g., other layers of the generator illustrated in Figure 4A) may be adapted to use streaming compatible layers (e.g., causal convolutions). This may prevent paddings on short sequences from causing discontinuities.

The generator described above (and, potentially, the entire machine-learned model 330, such as the entire GAN) and/or the training algorithm used to train the generator (e.g., the machine-learning training algorithm 320) may provide a non-parallel voice conversion approach that is capable of producing naturally sounding speech with limited data (e.g., limited input from a user via the microphone 130). The generator(s) / machine-learned model 330 described herein may be capable of performing such a conversion without F₀ modification, synthetic speaker data, or alignment procedures (e.g., by the introduction of an attention module in place of the 1-D latent ResNet module and/or based on a regularization parameter applied during training of the machine-learned model 330 in order to stabilize training). In addition to resulting in more naturally sounding speech, the machine-learned model 330 described herein (e.g., the generator of the GAN as illustrated in Figure 4A) may provide the ability to simulate (e.g., by a user who has had a laryngectomy) emotions in speech (e.g., in real-time). In other words, the machine-learned model 330 described herein may provide natural prosody, improved intelligibility, and naturalness in real-time for laryngeally impaired people (e.g., laryngectomees). In some embodiments, the generator (e.g., as illustrated in Figure 4A) may be capable of doing so by recreating speech that sounds as much like the original voice of the speaker as possible (e.g., the voice of the user before undergoing a laryngectomy) based on the training of the one or more generators. The one or more generators may recreate speech that sounds like the original voice by duplicating the frequency range of the original voice, the rise and fall times of the original voice, the glottal pulse of the original voice, and/or other characteristics of the original voice when producing a snippet with improved intelligibility. Still further, the one or more generators described above may be configured to allow a user (e.g., based on the user's input to a microphone, such as the microphone 130 shown and described with reference to Figure 1B) to change the mood of the artificially produced speech through various algorithms which modify calmness, levity, anger, friendship, command, etc., by altering prosody settings. Such alterations may be done based on changes in the user's captured snippets of unintelligible speech, for example.

A discriminator according to example embodiments is illustrated in Figure 4B. The discriminator in Figure 4B may have been trained according to a machine-learning training algorithm (e.g., the machine-learning training algorithm 320 shown and described with reference to Figure 3A) along with the generator illustrated in Figure 4A. For example, a two-step adversarial loss process may have been implemented to train the one or more generators and the one or more discriminators (e.g., using labeled training data including training data with high intelligibility). As described above, the discriminator may have been trained using a stop gradient function. The stop gradient function may be used to skip updating the one or more discriminators D during a step of the training (e.g., during gradient descent) when the discriminator loss is less than a predetermined threshold (e.g., 0.2). This may prevent mode collapse during training of the one or more discriminators D and stabilize the training of the GAN (e.g., by preventing the one or more discriminators from encouraging the one or more generators from collapsing towards minor, unperceivable changes in order to fool the one or more discriminators). As illustrated in Figure 4B, the discriminator may follow a similar architecture to PatchGAN (e.g., as introduced in Conditional GAN - *"*Image-to-Image Translation with Conditional Adversarial Networks;" Phillip Isola, et al.; arXiv:1611.07004; originally published on November 21, 2016). PatchGAN may include a convolution artificial neuron layer as the final artificial neuron layer of the ANN. Such a layer may permit the one or more discriminators to distinguish data based on the overall structure of the input, as well as reduce the number of parameters used to train the GAN and may provide stability during training of the GAN. Similar to at least one of the discriminators described in CycleGAN-VC2, a discriminator used herein may include an ensemble of four discriminators for two-step adversarial losses.

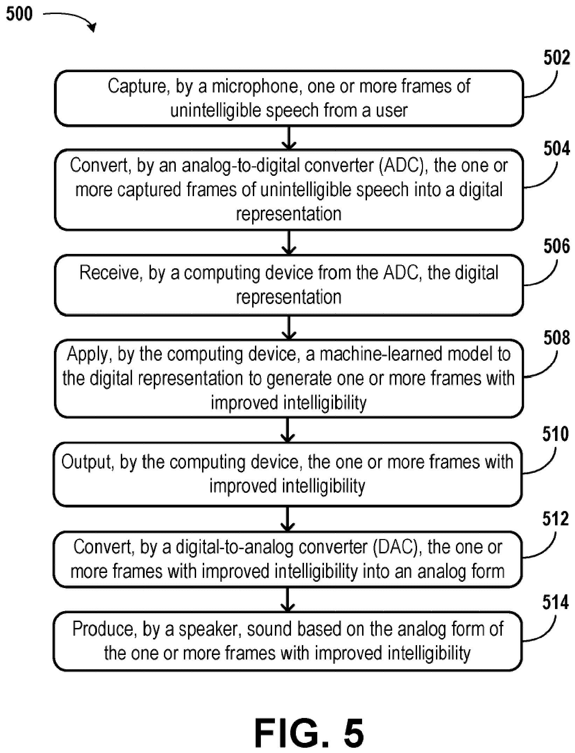

Figure 5 is a flowchart diagram of a method 500, according to example embodiments. In some embodiments, the method 500 may be performed, in part, using a device for real-time speech output with improved intelligibility (e.g., the device 110 shown and described with reference to Figure 1B). For example, a user (e.g., a laryngectomee) may use the device 110 to perform the method 500.

At step 502, the method 500 may include capturing, by a microphone (e.g., the microphone 130 shown and described with reference to Figure 1B), one or more frames of unintelligible speech from a user.

At step 504, the method 500 may include converting, by an ADC (e.g., the ADC 140 shown and described with reference to Figure 1B), the one or more captured frames of unintelligible speech into a digital representation.

At step 506, the method 500 may include receiving, by a computing device (e.g., the computing device 150 shown and described with reference to Figures 1B and 1C) from the ADC, the digital representation.

At step 508, the method 500 may include applying, by the computing device (e.g., the computing device 150 shown and described with reference to Figures 1B and 1C), a machine-learned model to the digital representation to generate one or more frames with improved intelligibility.

At step 510, the method 500 may include outputting, by the computing device (e.g., the computing device 150 shown and described with reference to Figures 1B and 1C), the one or more frames with improved intelligibility.

At step 512, the method 500 may include converting, by a DAC (e.g., the DAC 160 shown and described with reference to Figure 1B), the one or more frames with improved intelligibility into an analog form.

At step 514, the method 500 may include producing, by a speaker (e.g., the speaker 190 shown and described with reference to Figure 1B), sound based on the analog form of the one or more frames with improved intelligibility.

In some embodiments of the method 500, the machine-learned model applied at step 508 may be trained using training data that includes one or more recordings or representations of natural speech.

In some embodiments of the method 500, the machine-learned model applied at step 508 may be trained using training data that includes one or more recordings or representations of speech produced by a laryngectomee.

In some embodiments of the method 500, the machine-learned model applied at step 508 may be trained using training data that includes one or more recordings or representations of alaryngeal speech. The one or more recordings or representations of alaryngeal speech may include recordings or representations of a predetermined type of alaryngeal speech, for example. Further, the predetermined type of alaryngeal speech used may be exhibited by the user (e.g., the user 102 using the speech-improvement device 110 to perform the method 500).

In some embodiments, the method 500 may be performed using a device that is configured such that a time delay between when the microphone captures one or more frames of unintelligible speech (e.g., at step 502) and when the speaker produces sound based on the analog form of the one or more frames with improved intelligibility (e.g., at step 514) is less than 50 ms.

In some embodiments of the method 500, the machine-learned model applied at step 508 may include a GAN.

In some embodiments of the method 500, the machine-learned model applied at step 508 may be trained using a two-step adversarial loss technique.

In some embodiments of the method 500, the machine-learned model applied at step 508 may be trained using training data that includes: one or more recordings or representations (e.g., mel-spectrograms) of one or more sounds from an ARCTIC dataset or VCTK dataset and/or one or more recordings or representations (e.g., mel-spectrograms) of one or more test subjects attempting to reproduce the one or more sounds from the ARCTIC dataset or VCTK dataset (e.g., through alaryngeal speech).

In some embodiments of the method 500, the machine-learned model applied at step 508 may be trained using training data that includes one or more recordings of the user (e.g., the user 102 using a speech-improvement device 110 to perform the method 500) prior to the user undergoing a laryngectomy. The one or more recordings of the user prior to the user undergoing the laryngectomy may be contained within answering machine recordings, home video recordings, or web-archived video.

In some embodiments of the method 500, the machine-learned model applied at step 508 may be training using training data that includes one or more recordings of a relative of the user (e.g., the user 102 using a speech-improvement device 110 to perform the method 500) or a person having similar characteristics as the user. For example, the training data may include one or more recordings of the person having similar characteristics as the user and the similar characteristics may include a same sex as the user, a similar age to the user (e.g., within 1 year of the user, within 2 years of the user, within 3 years of the user, within 4 years of the user, within 5 years of the user, within 6 years of the user, within 7 years of the user, within 8 years of the user, within 9 years of the user, or within 10 years of the user), a similar height to the user (e.g., within 1 cm of the user, within 2 cm of the user, within 3 cm of the user, within 4 cm of the user, within 5 cm of the user, within 6 cm of the user, within 7 cm of the user, within 8 cm of the user, within 9 cm of the user, or within 10 cm of the user), or a similar weight to the user (e.g., within 1 kg of the user, within 2 kg of the user, within 3 kg of the user, within 4 kg of the user, within 5 kg of the user, within 6 kg of the user, within 7 kg of the user, within 8 kg of the user, within 9 kg of the user, or within 10 kg of the user). Additionally or alternatively, the training data may include one or more recordings of a relative of the user (e.g., a sibling, a parent, or a child of the user).

In some embodiments of the method 500, step 510 may include outputting the one or more frames as a mel-spectrogram. In such embodiments, a DAC (e.g., the DAC used to perform step 512) may include a vocoder. Further, step 512 may include the vocoder generating an electrical signal based on the mel-spectrogram. Additionally, in some embodiments, the vocoder may, itself, include a machine-learned model (e.g., a machine-learned model that includes a GAN) that is trained to invert mel-spectrograms to waveforms.

In some embodiments of the method 500, the unintelligible speech from the user (e.g., captured by the microphone at step 502) may be a result of the user possessing a heavy accent or ALS. For example, the reason the speech from the user is unintelligible may be due to the user's heavy accent or the user having ALS.

In some embodiments of the method 500, the microphone used at step 502 may be configured to capture three frames of unintelligible speech from the user. For example, each of the three frames may be between 8 ms and 12 ms in length (i.e., duration). Further, the computing device used at step 508 to apply the machine-learned model to the digital representation may be configured to generate a single frame with improved intelligibility based on the three captured frames of unintelligible speech. The single frame with improved intelligibility may be between 8 ms and 12 in length.

From the foregoing description it will be readily apparent that devices for real-time speech output with improved intelligibility that allow for more natural and more understandable speech have been developed. The naturalness may be provided by the inclusion of prosody; improvement of tonality; and an improved rendition of vowels, consonants, and other speech components. In some embodiments, devices described herein may be packaged to be worn or carried easily. Further, devices described herein may include and/or be powered by one or more batteries. The methods also described herein provide for processing speech in real-time to provide a more natural sounding output (e.g., based on an altered or impaired voice input). In certain cases where real-time speech is not necessary (e.g., when outside of the context of a live conversation, such as when a conversion after an utterance is acceptable), delayed speech with improved accuracy can also be provided (e.g., by applying a GAN that includes additional artificial neuron layers).

### III. Conclusion

The present disclosure is not to be limited in terms of the particular embodiments described in this application, which are intended as illustrations of various aspects. Many modifications and variations can be made without departing from its scope, as will be apparent to those skilled in the art. Functionally equivalent methods and apparatuses within the scope of the disclosure, in addition to those described herein, will be apparent to those skilled in the art from the foregoing descriptions. Such modifications and variations are intended to fall within the scope of the appended claims.

The above detailed description describes various features and operations of the disclosed systems, devices, and methods with reference to the accompanying figures. The example embodiments described herein and in the figures are not meant to be limiting. Other embodiments can be utilized, and other changes can be made, without departing from the scope of the subject matter presented herein. It will be readily understood that the aspects of the present disclosure, as generally described herein, and illustrated in the figures, can be arranged, substituted, combined, separated, and designed in a wide variety of different configurations.

With respect to any or all of the message flow diagrams, scenarios, and flow charts in the figures and as discussed herein, each step, block, operation, and/or communication can represent a processing of information and/or a transmission of information in accordance with example embodiments. Alternative embodiments are included within the scope of these example embodiments. In these alternative embodiments, for example, operations described as steps, blocks, transmissions, communications, requests, responses, and/or messages can be executed out of order from that shown or discussed, including substantially concurrently or in reverse order, depending on the functionality involved. Further, more or fewer blocks and/or operations can be used with any of the message flow diagrams, scenarios, and flow charts discussed herein, and these message flow diagrams, scenarios, and flow charts can be combined with one another, in part or in whole.

A step, block, or operation that represents a processing of information can correspond to circuitry that can be configured to perform the specific logical functions of a herein-described method or technique. Alternatively or additionally, a step or block that represents a processing of information can correspond to a module, a segment, or a portion of program code (including related data). The program code can include one or more instructions executable by a processor for implementing specific logical operations or actions in the method or technique. The program code and/or related data can be stored on any type of computer-readable medium such as a storage device including RAM, a disk drive, a solid state drive, or another storage medium.

The computer-readable medium can also include non-transitory computer-readable media such as computer-readable media that store data for short periods of time like register memory and processor cache. The computer-readable media can further include non-transitory computer-readable media that store program code and/or data for longer periods of time. Thus, the computer-readable media may include secondary or persistent long term storage, like ROM, optical or magnetic disks, solid state drives, compact-disc read only memory (CD-ROM), for example. The computer-readable media can also be any other volatile or non-volatile storage systems. A computer-readable medium can be considered a computer-readable storage medium, for example, or a tangible storage device.

Moreover, a step, block, or operation that represents one or more information transmissions can correspond to information transmissions between software and/or hardware modules in the same physical device. However, other information transmissions can be between software modules and/or hardware modules in different physical devices.

The particular arrangements shown in the figures should not be viewed as limiting. It should be understood that other embodiments can include more or less of each element shown in a given figure. Further, some of the illustrated elements can be combined or omitted. Yet further, an example embodiment can include elements that are not illustrated in the figures.

While various aspects and embodiments have been disclosed herein, other aspects and embodiments will be apparent to those skilled in the art. The various aspects and embodiments disclosed herein are for purpose of illustration and are not intended to be limiting, with the true scope being indicated by the following claims.

## Claims

1. A device comprising:
a microphone configured to capture one or more frames of unintelligible speech from a user;
an analog-to-digital converter (ADC) configured to convert the one or more captured frames of unintelligible speech into a digital representation;
a computing device configured to:
receive the digital representation from the ADC;
apply a machine-learned model to the digital representation to generate one or more frames with improved intelligibility; and
output the one or more frames with improved intelligibility;
a digital-to-analog converter (DAC) configured to convert the one or more frames with improved intelligibility into an analog form; and
a speaker configured to produce sound based on the analog form of the one or more frames with improved intelligibility.

2. The device of claim 1, wherein the machine-learned model was trained using training data comprising one or more recordings or representations of natural speech.

3. The device of claim 1 or claim 2, wherein the machine-learned model was trained using training data comprising one or more recordings or representations of speech produced by a laryngectomee.

4. The device of any preceding claim, wherein the machine-learned model was trained using training data comprising one or more recordings or representations of alaryngeal speech, and optionally wherein the one or more recordings or representations of alaryngeal speech comprise recordings or representations of a predetermined type of alaryngeal speech, and wherein the user exhibits the predetermined type of alaryngeal speech.

5. The device of any preceding claim, wherein the device is configured such that a time delay between when the microphone captures the one or more frames of unintelligible speech and when the speaker produces sound based on the analog form of the one or more frames with improved intelligibility is less than 50 ms.

6. The device of any preceding claim, wherein the machine-learned model comprises a generative adversarial network.

7. The device of claim 6:
wherein the machine-learned model is trained using a two-step adversarial loss technique, or
wherein the machine-learned model is trained using training data comprising:
recordings or representations of one or more sounds from an ARCTIC dataset or VCTK dataset; and
recordings or representations of one or more test subjects attempting to reproduce the one or more sounds from the ARCTIC dataset or VCTK dataset.

8. The device of any preceding claim, wherein the machine-learned model is trained using training data comprising one or more recordings of the user prior to the user undergoing a laryngectomy, and optionally wherein the one or more recordings of the user prior to the user undergoing the laryngectomy are contained within answering machine recordings, home video recordings, or web-archived video.

9. The device of any preceding claim, wherein the machine-learned model is trained using training data comprising one or more recordings of a relative of the user or a person having similar characteristics as the user.

10. The device of claim 9, wherein the training data comprises one or more recordings of the person having similar characteristics as the user, and wherein the similar characteristics comprise a same sex as the user, a similar age to the user, a similar height to the user, or a similar weight to the user, and/or wherein the training data comprises one or more recordings of the relative of the user, and wherein the relative is a sibling, a parent, or a child of the user.

11. The device of any preceding claim, wherein outputting the one or more frames within improved intelligibility comprises outputting the one or more frames as a mel-spectrogram, wherein the DAC comprises a vocoder, and wherein converting the one or more frames with improved intelligibility into the analog form comprises the vocoder generating an electrical signal based on the mel-spectrogram, and optionally wherein the vocoder comprises an additional machine-learned model that is trained to invert mel-spectrograms to waveforms, and wherein the additional machine-learned model comprises a generative adversarial network.

12. The device of any preceding claim, wherein the unintelligible speech from the user is a result of the user possessing a heavy accent or amyotrophic lateral sclerosis.

13. The device of any preceding claim, wherein the microphone is configured to capture three frames of unintelligible speech from the user, wherein each of the three frames is between 8 ms and 12 ms in length, wherein the computing device is configured to apply the machine-learned model to the digital representation to generate a single frame with improved intelligibility, wherein the single frame with improved intelligibility is between 8 ms and 12 ms in length.

14. A method comprising:
capturing, by a microphone, one or more frames of unintelligible speech from a user;
converting, by an analog-to-digital converter (ADC), the one or more captured frames of unintelligible speech into a digital representation;
receiving, by a computing device from the ADC, the digital representation;
applying, by the computing device, a machine-learned model to the digital representation to generate one or more frames with improved intelligibility;
outputting, by the computing device, the one or more frames with improved intelligibility;
converting, by a digital-to-analog converter (DAC), the one or more frames with improved intelligibility into an analog form; and
producing, by a speaker, sound based on the analog form of the one or more frames with improved intelligibility.

15. Computer instructions which, when executed by a processor, cause the processor to execute a method comprising:
receiving a digital representation from an analog-to-digital converter (ADC), wherein the digital representation was generated by the ADC from one or more frames of unintelligible speech from a user that were captured by a microphone;
applying a machine-learned model to the digital representation to generate one or more frames with improved intelligibility; and
outputting the one or more frames with improved intelligibility to a digital-to-analog converter (DAC), wherein the DAC is configured to:
convert the one or more frames with improved intelligibility into an analog form; and
output the analog form to a speaker that is configured to produce sound based on the analog form.
